# EUROPEAN PATENT SPECIFICATION

(11) **EP 1 089 428 B1**
(45) Date of publication and mention of the grant of the patent: **09.08.2006**
(21) Application number: 99125992.0
(22) Date of filing: 28.12.1999
(51) Int. Cl.: H03F 1/32

(54) **Nonlinear compensator**
Nichtlineare Korrekturvorrichtung
Compensateur non-linéaire

(30) Priority: 30.09.1999 JP 28034399
(43) Date of publication of application: 04.04.2001
(73) Proprietor: KABUSHIKI KAISHA TOSHIBA, Kawasaki-shi, Kanagawa-ken 210-8572 (JP)
(72) Inventor: Suga, Masaru, 1-1-1 Shibaura, Minato-ku Tokyo 105-8001 (JP); Isobe, Seiji, 1-1-1 Shibaura, Minato-ku Tokyo 105-8001 (JP); Sawada, Takeshi, 1-1-1 Shibaura, Minato-ku Tokyo 105-8001 (JP)
(74) Representative: HOFFMANN EITLE

(56) References cited:
- WO-A-99/05869
- WO-A-99/57806
- WO-A-99/66637
- US-A- 4 985 688
- US-A- 5 903 611
- US-A- 5 912 586
- US-A- 5 937 011

## Description

This invention relates to a nonlinear compensator for compensating for the nonlinear characteristic of a compensated electronic device that deals with a transfer signal.

WO 99/57806 A (non-prepublished) discloses a device wherein the phase of a carrier supplied from a carrier generator to an IQ modulator is controlled so as to compensate for the non-linearity of an RF amplifier.

WO 99/66637 A (non-prepublished) and US-A-5 912 586 disclose devices wherein errors may be detected in a feedback loop and distortions in a feed forward arrangement may be detected.

Further, WO 99/05869 A, US-A-4 9985 688, US-A-5 903 611 and US-A-5 937 011 disclose devices having components of non-linear characteristics.

However, all said prior art devices are based on use of digital baseband input signals.

Further, in analog television broadcasting, the signal peak value is determined by a synchronous peak value and therefore is almost constant. Synchronization is maintained in the vicinity of the clip value. Therefore, phase distortion occurring in the vicinity of the clip level need not be taken into account and only synchronous amplitude has to be corrected so that the synchronization length may be the same. In addition, since the peak factor (peak value/average value) is relatively small, the linearity in the low-level signal region is not required much.

On the other hand, in a next generation of digital terrestrial television broadcast, use by an OFDM (orthogonal frequency division multiplex) system has been decided and various efforts have been made to put the OFDM system to practical use. In the OFDM system, because of the character of the OFDM signal, the peak factor is much greater than that in the analog television broadcasting. As a result, the linearity ranging from a low level to a high level is required in the OFDM system. Additionally, since the phase of each carrier plays a key role in information transmission, even a slight distortion in the phase rotation leads to degradation of the characteristic. Therefore, the nonlinear characteristic and phase rotation are required to be compensated for accurately.

As described above, in the digital signal transmission by the OFDM system, the nonlinear characteristic is required to be compensated for accurately. Since there have not been such needs in the conventional analog system, the development of a device that meets the requirements has been wanted.

It is, accordingly, an object of the present invention to provide a nonlinear compensator which is easy to adjust and capable of making adaptive compensation for the nonlinear characteristic and phase rotation that vary with season, weather, and time. The foregoing object is accomplished by providing a nonlinear compensator according to claim 1.

Improvements thereof are in accordance with sub-claim. More specifically, such a nonlinear compensator for compensating for the nonlinear characteristic of a compensated electronic device that deals with a transfer signal, characterized comprises: a signal processing section which takes in the input signal and output signal of the compensated electronic device, demodulates the signals suitably in such a manner that they have the same signal form, senses the time difference and phase difference between the two signals by correlating the two signals with each other, and synchronizes the two signals with each other and causes the phase of one signal with that of the other on the basis of the detected time difference and phase difference; a distortion detecting section for detecting, as distortion components, an amplitude error and phase error in the input signal and output signal of the compensated electronic device that have been synchronized with each other and caused to coincide in phase with each other by the signal processing section; and a distortion correcting section for producing the amount of nonlinear distortion compensation for the compensated electronic device on the basis of the distortion components sensed by the distortion detecting section and compensating for the input signal to the compensated electronic device on the basis of the amount of distortion compensation.

This summary of the invention does not necessarily describe all necessary features so that the invention may also be a sub-combination of these described features.

The invention can be more fully understood from the following detailed description when taken in conjunction with the accompanying drawings, in which:
FIG. 1 is a block diagram of an OFDM transmitting device to which the present invention is applied;
FIG. 2 is a block diagram of a nonlinear compensator for compensating for the nonlinear characteristic of the RF amplifier of FIG. 1 according to an embodiment of the present invention;
FIG. 3 is a block diagram showing a concrete configuration of the distortion compensating section in the embodiment;
FIG. 4 is a block diagram of a nonlinear compensator according to another embodiment of the present invention;
FIGS. 5A and 5B are waveform diagrams to help explain an accurate synchronizing process in the embodiment of FIG. 4; and
FIGS. 6A and 6B are characteristic diagrams to help explain the accurate synchronizing process in the embodiment of FIG. 4.

Hereinafter, referring to the accompanying drawings, embodiments of the present invention will be explained.

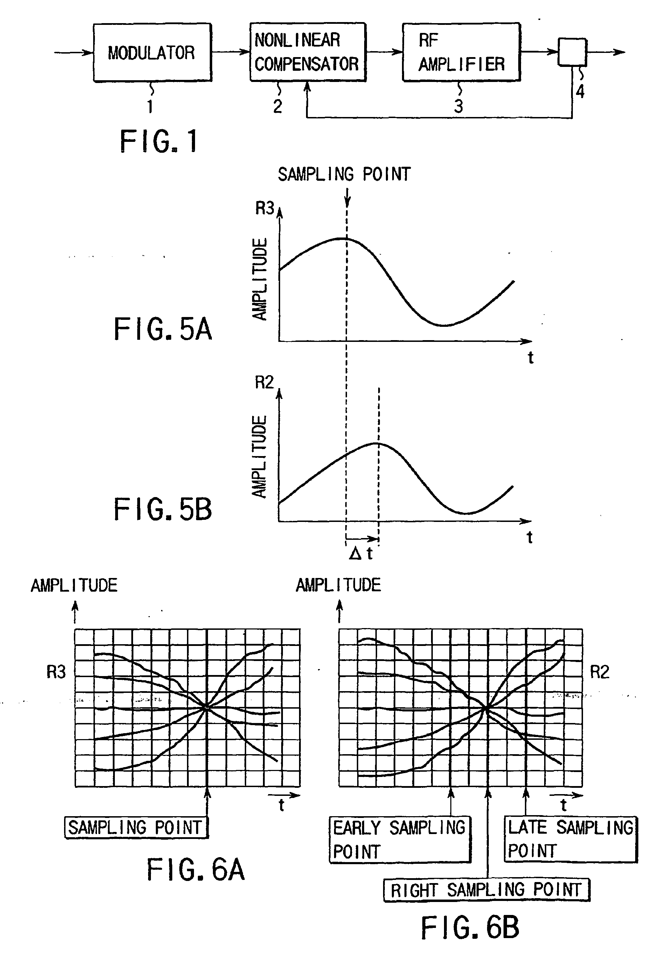

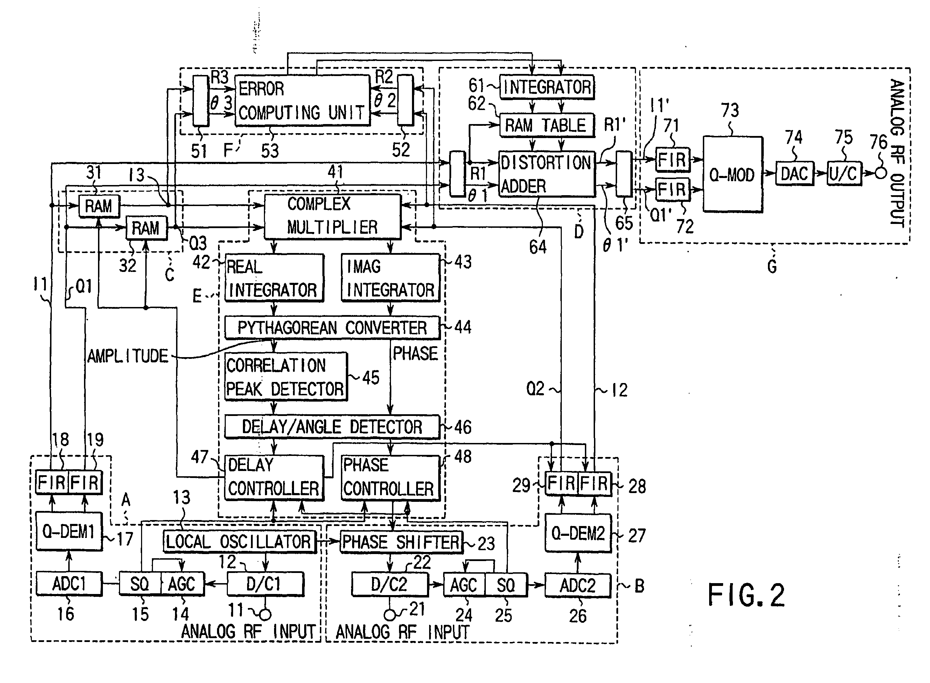

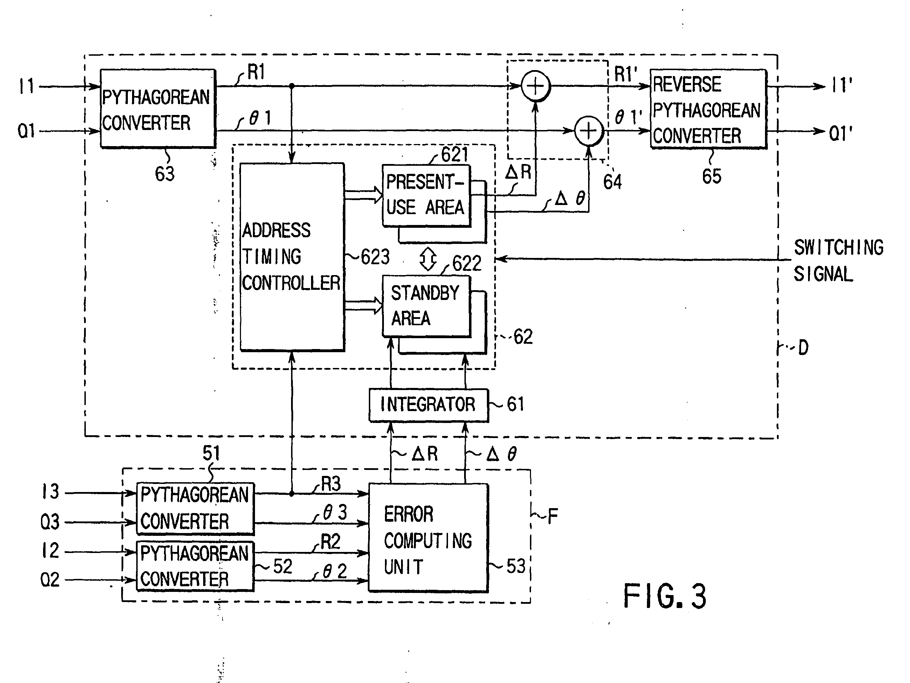

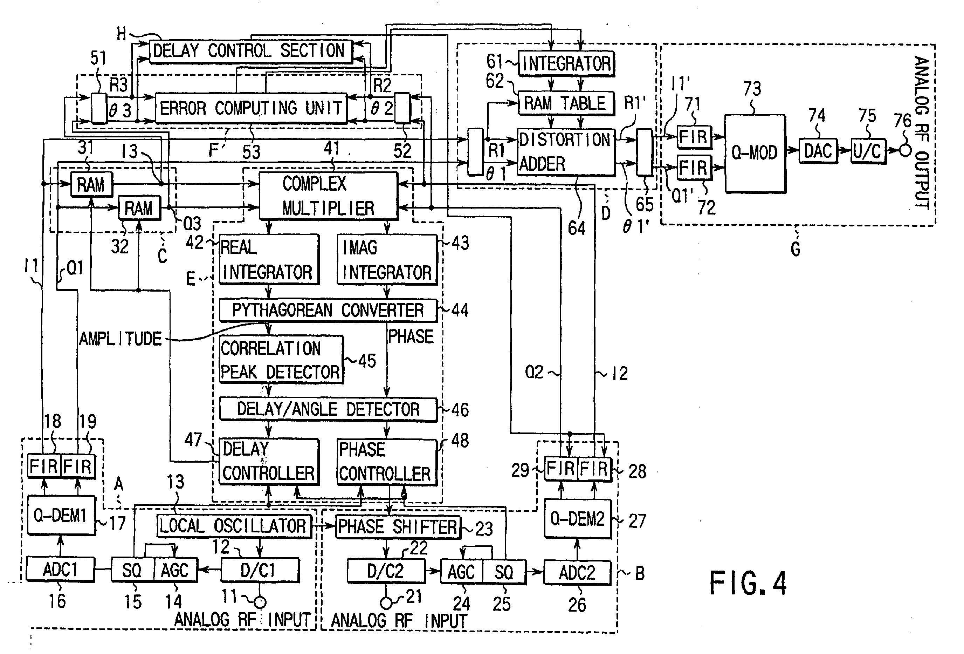

FIG. 1 shows the configuration of an OFDM transmitting device to which the present invention is applied. In the OFDM transmitting device, a modulator 1 outputs an RF OFDM signal. The OFDM signal passes through a nonlinear compensator 2 related to the present invention and is supplied to an RF amplifier 3. The RF amplifier 3 amplifies the power of the supplied signal and outputs the resulting signal as a transmitting signal. Part of the output of the RF amplifier 3 is distributed by a distributor (a directional coupler) 4 and supplied to the nonlinear compensator 2.

FIG. 2 shows the configuration of the nonlinear compensator 2. In FIG. 2, the RF signal from the modulator 1 is supplied to an analog RF input terminal 11. The RF signal supplied to the terminal 11 is converted by a down converter (D/C1) 12 into an IF signal on the basis of the local signal from a local oscillator 13. An AGC (automatic gain control) circuit 14 stabilizes the IF signal to a specific amplitude level. A squelch (SQ) circuit 15 judges whether or not the output of the AGC circuit 14 is present. The output of the AGC circuit 14 is converted by an analog/digital converter (ADC1) 16 into a digital IF signal. Thereafter, the digital IF signal is demodulated by a quadrature demodulation (Q-DEM) circuit 17, thereby producing digital base band signals I1, Q1 in complex form. The I1 and Q1 signals obtained are down-sampled by FIR filters (or LPF) 18, 19, if necessary. Those circuits constitute an input demodulation section A.

On the other hand, the RF signal outputted from the RF amplifier 3 is supplied to an analog PA input terminal 21. The RF signal supplied to the terminal 21 is converted by a second down converter (D/C2) into an IF signal on the basis of the local signal phase-adjusted by a phase shifter 23. The IF signal is stabilized by an AGC circuit 24 to a specific amplitude level. A squelch (SQ) circuit 25 judges whether or not the output of the AGC circuit 24 is present. The output of the AGC circuit 24 is converted by an analog/digital converter (ADC2) 26 into a digital IF signal. Thereafter, the digital IF signal is demodulated by a quadrature demodulation (Q-DEM) circuit 27, thereby producing digital base band signals I2, Q2 in complex form. The I2 and Q2 signals obtained are down-sampled by FIR filters (or LPF) 28, 29, if necessary. Those circuits constitute an output demodulation section B.

The digital base band signals I1, Q1 outputted from the input demodulation section A are inputted to a delay adjusting section C and a distortion correcting section D. The delay adjusting section C includes RAM delay units 31, 32 for delaying the digital base band signals I1, Q1 outputted from the input demodulation section A for a specific time. The digital base band signals I3, Q3 delayed by the RAM delay units 31, 32, together with the digital base band signals I2, Q2 outputted from the output demodulation section B, are supplied to a delay detecting section E and a distortion detecting section F.

In the delay detecting section E, the base band signals I3, Q3 from the delay adjusting section C and the base band signals I2, Q2 from the output demodulation section B are supplied to a complex multiplier 41. The complex multiplier 41 calculates (13 + jQ3) × (I*2 + jQ*2) or (I*3 + jQ*3 × (I2 + jQ2) with complex conjugates of I3, Q3 being expressed as I*3, Q*3 and those of I2, Q2 as I*2, Q*2. Thereby, the complex multiplier 41 finds a complex correlation between both input signals and produces a REAL (real part) signal and an IMAG (imaginary part) signal. The REAL signal and IMAG signal obtained are supplied to a REAL integrator 42 and an IMAG integrator 43.

These integrators 42, 43 remove the effects of noise or the like by integrating an interval to find, for example, a cumulative value/cumulative time. The outputs of the integrators 42, 43 are supplied to a Pythagorean converter 44, which converts the Cartesian coordinates into polar coordinates. Of the outputs of the Pythagorean converter 44, the amplitude value is supplied to a correlation peak sensor 45. The correlation peak detector 45 determines the peak position in the correlative output of two input signals. The peak position information detected at the correlation peak detector 45, together with the angle value (phase value) outputted from the Pythagorean converter 44, is supplied to a delay/angle sensor 46.

From the peak position information, the delay/angle detector 46 determines the time difference and phase difference (angle difference) between the digital base band signals I3, Q3 on the amplifier input side and the digital base band signals I2, Q2 on the amplifier output side. The time difference obtained is supplied to a delay controller 47 and the phase difference is supplied to a phase controller 48. According to the time difference, the delay controller 47 sets not only the amount of delay in the RAM delay units 31, 32 of the delay adjusting section C to perform rough synchronization, but also the value of coefficient in the FIR filters 28, 29 in the output demodulation section B to perform precise synchronization. This enables the digital base band signals I3, Q3 on the amplifier input side to be synchronized with the digital base band signals I2, Q2 on the amplifier output side. In addition, the phase controller 48 adjusts the amount of phase shift in the phase shifter 23 of the output demodulation section B according to the supplied phase difference. This causes the phase on the amplifier input side to coincide with the phase on the amplifier output side.

When the digital base band signals include no signal component, the delay controller 47 and phase controller 48 can obtain neither the time difference nor the phase difference and therefore might be uncontrollable and operate erroneously. To avoid this, the presence or absence of signal components is judged from the outputs from the squelch circuits 15, 25 provided in the input modulation section A and output demodulation section B. Only when there is any signal component, control is performed.

In the distortion detecting section F, Pythagorean converters 51, 52 convert the Cartesian coordinates (I3, Q3), (I2, Q2) of the digital base band signals I3, Q3 from the delay adjusting section C and the digital base band signals I2, Q2 from the output demodulation section B into the polar coordinates (R3, θ3), (R2, θ2) of them. Thereafter, an error computing unit 53 determines the amplitude error and phase error in them. The amplitude error ΔR and phase error Δθ obtained are supplied to a distortion correcting section D.

In the distortion correcting section D, an integrator 61 integrates the amplitude error ΔR and phase error Δθ from the distortion detecting section F over an interval. The integration result is registered as the amount of distortion compensation in a RAM table 62. On the other hand, after a Pythagorean converter 64 converts the Cartesian coordinates (I1, Q1) of the digital base band signals I1, Q1 from the input modulation section A into the polar coordinates (R1, θ1). Thereafter, the amount of distortion compensation (ΔR, Δθ) corresponding to the value of R1 is read from the RAM table 62. An amount-of-distortion compensation adding section 63 adds the amount of distortion compensation to the obtained polar coordinates. The resulting values are converted by a reverse Pythagorean converter 65 into the original Cartesian coordinates (I1', Q1'). The digital base band signals outputted from the distortion correcting section D are supplied to an output converting section G.

In the output converting section G, the input digital base band signals are returned by FIR filters (or LPF) 71, 72 to the original bit rate (by oversampling). The resulting signals are modulated by a quadrature modulation (Q-MOD) circuit 73 into an IF signal, which is then converted by a digital/analog converter (DAC) 74 into an analog signal. Thereafter, an UP converter (U/C) 75 converts the analog signal into an RF signal, which is outputted as a distortion-compensated signal at an RF output terminal 76.

Next, a concrete configuration of the distortion correcting section D will be explained.

FIG. 3 shows the configuration of the distortion correcting section D and the relationship with the distortion detecting section F. A RAM table 62 in the distortion correcting section D includes a present-use area 621 and a standby area 622 in a dual port memory, which are designed to operate independently. Each of the present-use area and standby area 622 has an amplitude value (R) section and a angle (θ) section. When a switching signal is externally given, the data written in the standby area 622 is moved to the present-use area 621.

The standby area 622 is written into and the present-use area is read from according to the address from an address timing control section 623. Specifically, the address timing control section 623 takes in the polar-coordinate-converted amplitude value data R3 of the input-side base band signal from the distortion detecting section F at the time of initial setting and generates a write address for the standby area 622. Then, the address timing control section 623 writes the amounts of distortion compensation (ΔR, θΔ) from the integrator 61 into the standby area 622 by amplitude value (ΔR) and by angle (θΔ) in such a manner that they correspond to R3, thereby creating updated data on the amounts of distortion compensation. In addition, the address timing control section 623 takes in the R1 data from the Pythagorean converter 63 of the distortion correcting section D in service and generates a read address for the present-use area 621. Then, it reads the corresponding amounts of distortion compensation by amplitude value (ΔR) and by angle (θΔ) and sends them to the amount-of-distortion-compensation adding section 64.

The timing of switching between the present-use area 621 and standby area 622 is such that the amounts of distortion compensation accumulated in the integrator 61 during a specific period ranging from when power is turned on to when resetting is done are written into the standby area 622, and thereafter the data in the standby area 622 is moved to the present-use area 621.

As described above, in the nonlinear compensator 2 of the present embodiment, the input modulation section A and output demodulation section B extract the digital base band signals in the RF input and RF output of the RF amplifier 3. The delay detecting section E detects the time difference and phase difference between the two signals by calculating correlation. The delay adjusting section C synchronizes the two signals with each other. Moreover, the phase shifter 23 causes the phase of one signal to coincide with that of the other. In this state, the distortion detecting section F determines the amplitude error and phase error in the two signals and inputs the errors as distortion components to the distortion correcting section D. The distortion correcting section D sequentially selects the amounts of compensation corresponding to the amplitude values from the amounts of compensation registered in the aforementioned means and adds the amount of compensation to the digital base band signals obtained at the input modulation section A to compensate for the distortion component. Then, the output converting section G converts the resulting signal into a signal in the original format and outputs the converted signal to the RF amplifier 3. This enables the RF signal having the opposite of the nonlinear characteristic of the RF amplifier 3 to be inputted to the RF amplifier 3, thereby compensating for the distortion components caused by the nonlinear characteristic of the RF output.

The amount of compensation is updated at the time of turning on the power or resetting as well as at the time of normal operation. Thus it is easy to adjust the amount of compensation, and this makes it possible to make adaptive compensation for the nonlinear characteristic and phase rotation which vary with season, weather, or time.

Moreover, the output value of the distortion detecting section F is monitored. When the output value has exceeded a reference value, it is judged that an abnormality has occurred and an alarm is given, thereby informing the manager of the malfunction of the RF amplifier 3 or the like as soon as possible.

The present invention is not limited to the above embodiment.

For instance, while in the above embodiment, the coefficient values in the FIR filters 28, 29 in the output demodulation section B are controlled to perform precise synchronization, the coefficient values in the FIR filters 18, 19 in the input demodulation section A may be controlled to perform precise synchronization.

Furthermore, while in the above embodiment, the phases are caused to coincide with each other by adjusting the amount of phase shift in the phase shifter 23 of the output demodulation section B, the phases may be caused to coincide with each other by causing the phase shifter to adjust the phase of the local signal supplied to the down converter 12 of the input demodulation section A.

Additionally, in the above embodiment, the modulator 1 has inputted an analog RF signal. When the modulator 1 outputs a digital base band signal directly, the digital base band signal may be supplied directly to the delay adjusting section C and distortion correcting section D in place of the output of the input demodulation section A, which produces the same effect as that of the above embodiment.

Still furthermore, in the above embodiment, the present invention has been applied to the OFDM transmitting device, the invention is not limited to this. For instance, the invention may be applied to compensating for the nonlinear characteristic and phase rotation in the electronic circuitry of another analog communication system or digital communication system, such as a transmitting device for NTSC analog television signals or an transmitting device for ATSC digital television signals.

While in the above embodiment, the delay controller 47 of the delay detecting section E controls the coefficient values in the FIR filters 28, 29 of the output demodulation section B to perform precise synchronization, the present invention is not restricted to this. For instance, as shown in FIG. 4, the signals (R3, θ3), (R2, θ2) from the Pythagorean converters 51, 52 to the error computing unit 53 in the distortion detecting section F may be inputted to a delay control section H. The delay control section H then may determine an error between the two signals, and control the FIR filters 28, 29 so as to minimize the error. This realizes similar precise synchronization. In FIG. 4, the same parts as those in FIG. 2 are indicated by the same reference symbols and explanation of them will be omitted.

The process of performing precise synchronization using the inputs (R3, θ3), (R2, θ2) to the error computing unit 53 will be explained below.

FIGS. 5A and 5B show a comparison between the change of amplitude R3 and that of amplitude R2 among the inputs to the delay control section H. As seen from the figure, when the sampling point of R3 does not coincide with the sampling point of R2, another point in the waveform of R2 is sampled, leading to great variations in the distortion components obtained from the instantaneous values R2 and R3. FIGS. 6A and 6B show the relationship between the sampling point and variations. As is apparent from the figures, variations can be minimized when the sampling point of R2 coincides with that of R3. This holds true for angles of θ2 and θ3. Thus, the delay control section H senses the time difference between the sampling point of (R3, θ3) and that of (R2, θ2) and controls the FIR filters 28, 29 so as to minimize the time difference, thereby realizing precise synchronization.

While in the above embodiment, distortion has been corrected by adding polar coordinates (R, θ), the same thing can be done by multiplying Cartesian coordinates (I, Q).

Furthermore, while in the above embodiment, the full loop configuration enables automatic adjustment and automatic control to make adaptive compensation for the nonlinear characteristic and phase rotation, the sense result of each detecting section may be displayed suitably and the user may adjust or correct the characteristic or rotation manually, while watching what has been displayed.

As described above, with the present invention, it is possible to provide a nonlinear compensator which is easy to adjust and capable of making adaptive compensation for the nonlinear characteristic and phase rotation that vary with season, weather, and time.

## Claims

1. A nonlinear compensator for compensating for the nonlinear characteristic of a compensated electronic device (3) that deals with a transfer signal, comprising
a signal processing section (A, B, C, E) which takes in the input signal and output signal of the compensated electronic device (3), demodulates the signals suitably in such a manner that they have the same signal form, senses the time difference and phase difference between two signals by correlating the two signals with each other, and synchronizes the two signals with each other and causes the phase of one signal to coincide with that of the other on the basis of the detected time difference and phase difference;
a distortion detecting section (D) for detecting, as distortion components, an amplitude error and phase error in the input signal and output signal of said compensated electronic device (3) that have been synchronized with each other and caused to coincide in phase with each other by the signal processing section (A, B, C, E); and
a distortion correcting section (D) for producing the amount of nonlinear distortion compensation for said compensated electronic device on the basis of the distortion section (F) and compensating for the input signal to said compensated electronic device (3) on the basis of the amount of distortion compensation;
wherein
said signal processing section (A, B, C, E)
including an input demodulation section (A) for generating an input-side base band signal by demodulating the transfer signal to said compensated electronic device (3) and an output demodulation section (B) for generating an output-side base band signal by demodulating the transfer signal outputted from said compensated electronic device (3),
detecting the time difference and phase difference between the input side and output side base band signals obtained at said input demodulation section (A) and output demodulation section (B), and
synchronizing the two signals with each other and causing the phase of one signal to coincide with that of the other on the basis of the detected time difference and phase difference; and
said signal processing section (A, B, C, E) further including an output processing section (G) for converting the output of said distortion correcting section (D) into the format of the original transfer signal.

2. The nonlinear compensator according to claim 1, wherein said signal processing section (A, B, C, E) delays the input signal to said compensated electronic device according to the amount of delay corresponding to the detected time difference.

3. The nonlinear compensator according to claim 1 or 2, wherein said signal processing section (A, B, C, E) gives an amount of phase shift corresponding to the detected phase difference to the input signal or output signal of said compensated electronic device.

4. The nonlinear compensator according to any of the preceding claims, wherein said distortion correcting section (D) includes an amount-of-compensation table (62) for holding said amount of distortion compensation, registers said amount of distortion compensation at the time of initial setting, reads the amount of distortion compensation corresponding to an amplitude of the input signal to said compensation electronic device from the amount-of-compensation table (62) in service, and adds the amount to the input signal.

5. The nonlinear compensator according to claim 4, wherein the amount-of-compensation table (62) in said distortion correcting section (D) includes a present-use table (621) and a standby table (622), stores the amount of distortion compensation obtained at said distortion detecting section (F) and, after the storage has been completed, replaces the present use table (621) with the standby table (622).

6. The nonlinear compensator according to any of the preceding claims, further comprising monitor means for monitoring said compensated electronic device (3) by monitoring the distortion components obtained at said distortion detecting section (F).

## Patentansprüche

1. Nichtlinearer Kompensator zum Kompensieren der nichtlinearen Eigenschaft einer kompensierten elektronischen Vorrichtung (3), welche ein Übertragungssignal behandelt, mit:
einer Signalverarbeitungssektion (A, B, C, E), welche das Eingangssignal und Ausgangssignal der kompensierten elektronischen Vorrichtung (3) aufnimmt, die Signale entsprechend auf eine solche Weise demoduliert, dass sie dieselbe Signalform haben, die Zeitdifferenz und Phasendifferenz zwischen zwei Signalen durch ein Korrelieren der zwei Signale miteinander abtastet, und die zwei Signale miteinander synchronisiert, und die Phase von einem Signal mit der des anderen auf Basis der erfassten Zeitdifferenz und Phasendifferenz in Übereinstimmung bringt;
einer Verformungs-Erfassungssektion (D) zum Erfassen als Verformungskomponenten von einem Amplitudenfehler und Phasenfehler im Eingangssignal und Ausgangssignal der kompensierten elektronischen Vorrichtung (3), welche miteinander synchronisiert wurden, und welche durch die Signalverarbeitungssektion (A, B, C, E) bewirkt wurden, in der Phase miteinander übereinzustimmen; und
einer Verformungs-Korrektursektion (D) zum Erzeugen der Größe einer nichtlinearen Verformungskompensation für die kompensierte elektronische Vorrichtung auf Basis der Verformungssektion (F), und Kompensieren des Eingangssignals an die kompensierte elektronische Vorrichtung (3) auf Basis der Größe der Verformungskompensation;
wobei
die Signalverarbeitungssektion (A, B, C, E)
eine Eingangs-Demodulationssektion (A) zum Erzeugen eines eingangsseitigen Basisbandsignals durch Demodulieren des Übertragungssignals an die kompensierte elektronische Vorrichtung (3) und eine Ausgangs-Demodulationssektion (B) zum Erzeugen eines ausgangsseitigen Basisbandsignals durch Demodulieren des von der kompensierten elektronischen Vorrichtung (3) ausgegebenen Übertragungssignals enthält,
die Zeitdifferenz und Phasendifferenz zwischen dem eingangsseitigen und ausgangsseitigen Basisbandsignal, welche an der Eingangs-Demodulationssektion (A) und Ausgangs-Demodulationssektion (B) erlangt werden, erfasst, und
die zwei Signale miteinander synchronisiert und bewirkt, dass die Phase von einem Signal mit der des anderen auf Basis der erfassten Zeitdifferenz und Phasendifferenz übereinstimmt; und
wobei die Signalverarbeitungssektion (A, B, C, E) ferner eine Ausgangsverarbeitungssektion (G) zum Umwandeln des Ausgangs der Verformungs-Korrektursektion (D) in das Format des ursprünglichen Übertragungssignals enthält.

2. Nichtlinearer Kompensator nach Anspruch 1, bei welchem die Signalverarbeitungssektion (A, B, C, E) das Eingangssignal an die kompensierte elektronische Vorrichtung gemäß der Verzögerungsgröße entsprechend der erfassten Zeitdifferenz verzögert.

3. Nichtlinearer Kompensator nach Anspruch 1 oder 2, bei welchem die Signalverarbeitungssektion (A, B, C, E) eine Größe von einer Phasenverschiebung entsprechend der erfassten Zeitdifferenz an das Eingangssignal oder Ausgangssignal der kompensierten elektronischen Vorrichtung gibt.

4. Nichtlinearer Kompensator nach einem der vorhergehenden Ansprüche, bei welchem die Verformungs-Korrektursektion (D) eine Kompensationsgröße-Tabelle (62) zum Halten der Größe von einer Verformungskompensation enthält, die Größe von einer Verformungskompensation zum Zeitpunkt einer Anfangs-Einstellung registriert, die Größe von einer Verformungskompensation entsprechend einer Amplitude des Eingangssignals an die kompensierte elektronische Vorrichtung von der Kompensationsgröße-Tabelle (62) im Dienst ausliest, und die Größe dem Eingangssignal hinzufügt.

5. Nichtlinearer Kompensator nach Anspruch 4, bei welchem die Kompensationsgröße-Tabelle (62) in der Verformungs-Korrektursektion (D) eine Momentanverwendungs-Tabelle (621) und eine Bereitschafts-Tabelle (622) enthält, die Größe von einer Verformungskompensation, welche an der Verformungs-Erfassungssektion (F) erlangt wird, speichert, und, nachdem die Speicherung vollendet ist, die Momentanverwendungs-Tabelle (621) durch die Bereitschafts-Tabelle (622) ersetzt.

6. Nichtlinearer Kompensator nach einem der vorhergehenden Ansprüche, welcher ferner ein Überwachungsmittel zum Überwachen der kompensierten elektronischen Vorrichtung (3), indem die an der Verformungs-Erfassungssektion (F) erlangten Verformungskomponenten überwacht werden, enthält.

## Revendications

1. Compensateur non-linéaire servant à compenser la caractéristique non-linéaire d'un dispositif électronique compensé (3) qui traite un signal de transfert, comprenant
une section de traitement du signal (A, B, C, E) qui prend le signal d'entrée et le signal de sortie du dispositif électronique compensé (3), démodule convenablement les signaux de telle manière qu'ils aient la même forme de signal, détecte la différence de temps et la différence de phase entre deux signaux en mettant les deux signaux en corrélation l'un avec l'autre, et synchronise les deux signaux l'un avec l'autre et amène la phase d'un signal à coïncider avec celle de l'autre sur la base des différences de temps et de phase détectées ;
une section de détection de distorsion (D) servant à détecter, en tant que composantes de distorsion, une erreur d'amplitude et une erreur de phase dans le signal d'entrée et le signal de sortie dudit dispositif électronique compensé (3) qui ont été synchronisés l'un avec l'autre et qui ont été amenés à coïncider dans leur phase l'un avec l'autre par le biais de la section de traitement du signal (A, B, C, E) ; et
une section de correction de distorsion (D) servant à produire la quantité de compensation de distorsion non-linéaire pour ledit dispositif électronique compensé sur la base de la section de distorsion (F) et à compenser le signal d'entrée vers ledit dispositif électronique compensé (3) sur la base de la quantité de compensation de distorsion ;
dans lequel
ladite section de traitement du signal (A, B, C, E)
comprend une section de démodulation d'entrée (A) servant à générer un signal de bande de base du côté entrée en démodulant le signal de transfert vers ledit dispositif électronique compensé (3) et une section de démodulation de sortie (B) servant à générer un signal de bande de base du côté sortie en démodulant le signal de transfert sortant dudit dispositif électronique compensé (3),
détecte la différence de temps et la différence de phase entre les signaux de la bande de base du côté entrée et du côté sortie obtenus au niveau desdites sections de démodulation d'entrée (A) et de démodulation de sortie (B), et
synchronise les deux signaux l'un avec l'autre et amène la phase d'un signal à coïncider avec celle de l'autre sur la base des différences de temps et de phase détectées ; et
ladite section de traitement du signal (A, B, C, E) comprend en outre une section de traitement de sortie (G) servant à convertir la sortie de ladite section de correction de distorsion (D) au format du signal de transfert d'origine.

2. Compensateur non-linéaire selon la revendication 1, dans lequel ladite section de traitement du signal (A, B, C, E) diffère le signal d'entrée vers ledit dispositif électronique compensé conformément à la quantité de retard correspondant à la différence de temps détectée.

3. Compensateur non-linéaire selon la revendication 1 ou 2, dans lequel ladite section de traitement du signal (A, B, C, E) fournit une quantité de déphasage correspondant à la différence de phase détectée au signal d'entrée ou au signal de sortie dudit dispositif électronique compensé.

4. Compensateur non-linéaire selon l'une quelconque des revendications précédentes, dans lequel ladite section de correction de distorsion (D) comprend un tableau de quantité de compensation (62) servant à contenir ladite quantité de compensation de distorsion, enregistre ladite quantité de compensation de distorsion au moment du réglage initial, lit la quantité de compensation de distorsion correspondant à une amplitude du signal d'entrée vers ledit dispositif électronique compensé provenant du tableau de quantité de compensation (62) en service, et ajoute la quantité au signal d'entrée.

5. Compensateur non-linéaire selon la revendication 4, dans lequel le tableau de quantité de compensation (62) dans ladite section de correction de distorsion (D) comprend un tableau d'utilisation actuelle (621) et un tableau de secours (622), stocke la quantité de compensation de distorsion obtenue au niveau de ladite section de détection de distorsion (F) et, après que le stockage soit terminé, remplace le tableau d'utilisation actuelle (621) par le tableau de secours (622).

6. Compensateur non-linéaire selon l'une quelconque des revendications précédentes, comprenant en outre un moyen de contrôle servant à contrôler ledit dispositif électronique compensé (3) en contrôlant les composantes de distorsion obtenues au niveau de ladite section de détection de distorsion (F).
